# EUROPEAN PATENT APPLICATION

(11) **EP 1 102 073 A1**
(43) Date of publication of application: **23.05.2001**
(21) Application number: 99650108.6
(22) Date of filing: 15.11.1999
(51) Int. Cl.: G01R 21/133

(54) **Real time flow monitoring**

(71) Applicant: Corcoran, Alexander Patrick, Ballina, County Mayo (IE)
(72) Inventor: Corcoran, Alexander Patrick, Ballina, County Mayo (IE)
(74) Representative: Weldon, Michael James

(57) **Abstract**

A flow monitoring system (1) has a housing (4) and a display (5) which provides real time electricity flow information. An LED (11) flashes at a rate proportional to the present consumption and a ramp (8) has a segment illuminated for the same purpose. Tamper detection circuits (54) are provided.

## Description

The invention relates to monitoring a medium in real time. The medium may be electricity, gas, oil, water, heat, telecommunication signals or any other medium for which consumers or users would benefit from dynamic real time flow information. Typically, a parameter being measured is energy flow.

PCT Patent Specification No. W082/03482 (Dupont Energy Management) describes a monitoring system which operates on the principle of sensing movement of an indicator at an electricity meter and placing high frequency pulses on the household electrical network. These pulses are sensed by a microprocessor and are processed to generate consumption information for the user. It appears that the work involved in installing such a system is quite involved technically and requires specialist skills. It also appears that the system lacks flexibility as it is restricted to use with electric meters.

PCT Patent Specification No. W086/05887 (Baram) describes a monitoring system which generates a display of the power consumed for a given appliance. It operates by monitoring voltage level from its mains supply and by monitoring current using a series resistance. While this device appears to be simpler to install, it is restricted to application to a single appliance. Therefore, the information it provides is not very comprehensive.

There is therefore a need for a system which is more flexible whereby it may be installed for use in monitoring the power delivered to all of a building, to only one circuit, or indeed to only one or more appliances.

Another very important object is to provide for easy and simple installation whereby the system may be installed by a consumer. This is to allow the system to be easily installed by the user for use as a "watchdog" on a supplier.

There is also a need to provide a system which has more versatility in the manner in which it is used so that consumers can have easy access to the information required irrespective of the layout of the building in which the monitoring is taking place.

Another object is to provide a system which allows monitoring of a medium other than electricity and, where electricity is the medium, whereby the system may be easily configured for monitoring one, two, or three phase supplies.

According to the invention, there is provided a real time flow monitoring system comprising:-
a flow interface comprising means for generating a flow signal representing flow of a medium being monitored; and
a user interface comprising means for processing the flow signal and for generating a user output of data such as cost in real time.

In one embodiment, the flow signal is frequency-modulated.

Preferably, the flow signal represents a flow unit as a pulse, whereby pulse frequency represents flow.

In one embodiment, the user interface comprises means for activating a light emitter to flash at a frequency related to flow to provide a strong visual indication.

In a further embodiment, the user interface comprises means for storing accumulated flow values between a reset time and the present time.

In one embodiment, the user interface comprises means for storing historical accumulated values for pre-set time periods.

In a further embodiment, the user interface comprises means for adding accumulated values for time periods which are repeated such as time 00.00 to 08.00 every day.

In a still further embodiment, the user interface comprises a display comprising a ramp in which flowrate is represented as a position on the ramp.

In one embodiment, the user interface comprises means for displaying both cost and flow data.

In a further embodiment, the user interface is connected in a tamper-detection circuit comprising means for detecting opening of a housing for the system.

In another embodiment, the user interface comprises means for generating an alarm output indicating a tampering occurrence and the alarm output preferably comprises a dedicated light emitter.

In one embodiment, the flow interface comprises means for sensing electricity consumption, and the flow interface comprises a current transformer connected to a current voltage converter.

In a further embodiment, the flow interface comprises a voltage divider connected to a power cable for the system.

In one embodiment, the current transformer comprises a base and a hinged part which co-operate to surround a cable and support a magnetic transformer in proximity to the cable.

In a further embodiment, the current transformer comprises a socket for a signal connector, and the socket is in the hinged part.

In a further embodiment, the user interface is located remotely from the flow interface.

In a still further embodiment, the flow interface and the user interface comprise means for wireless communication.

In one embodiment, the user interface comprises means for communication with a plurality of flow interfaces.

In a further embodiment, the user interface comprises means for processing electricity consumption flow signals from each of multiple phases.

In one embodiment, the flow interface comprises means for determining electrical consumption from an electricity meter.

In another embodiment, the flow interface comprises a sensor operable according to the shunt resistor power detection technique.

In one embodiment, the system comprises a housing for the user interface. the housing comprising a removable mounting plate for mounting on a wall.

In another embodiment, the housing and the mounting plate comprises a plurality of apertures and at least one blank piece to allow a plurality of paths for training signal and power cables into the circuits.

In one embodiment, a housing for the user interface comprises a cambered transparent section behind which a display is mounted.

In another embodiment, the display comprises means for allowing entry of light from above at an angle of up to 45°.

According to another aspect, the invention provides a current sensor comprising a body having means for non-intrusively surrounding an electrical cable to retain a current transformer in proximity to the cable, and an output port for delivery of a current sense signal to a monitoring device.

The invention will be more clearly understood from the following description of some embodiments thereof, given by way of example only with reference to the accompanying drawings in which:-
Fig. 1(a) to 1(i) are a set of diagrams illustrating an electricity flow monitoring system of the invention;
Fig. 2 is a front view of a display of the system;
Fig. 3 is a perspective view of a current transformer for non-intrusive monitoring of electricity current flow;
Fig. 4 is a set of views showing parts of the current transformer of Fig. 3 in more detail;
Figs. 5 and 6 are circuit diagrams of flow interface and user interface circuits of the system; and
Fig. 7 is a diagram showing an alternative system.

Referring to the drawings, there is shown a flow monitoring system 1. In this embodiment, the system is for electricity consumption monitoring in domestic or light industrial environments, however a system of the invention may equally be applicable to any industrial application. The system 1 comprises a circuit and display unit 2 which houses flow interface and user interface circuits and which receives inputs from a current transformer 3.

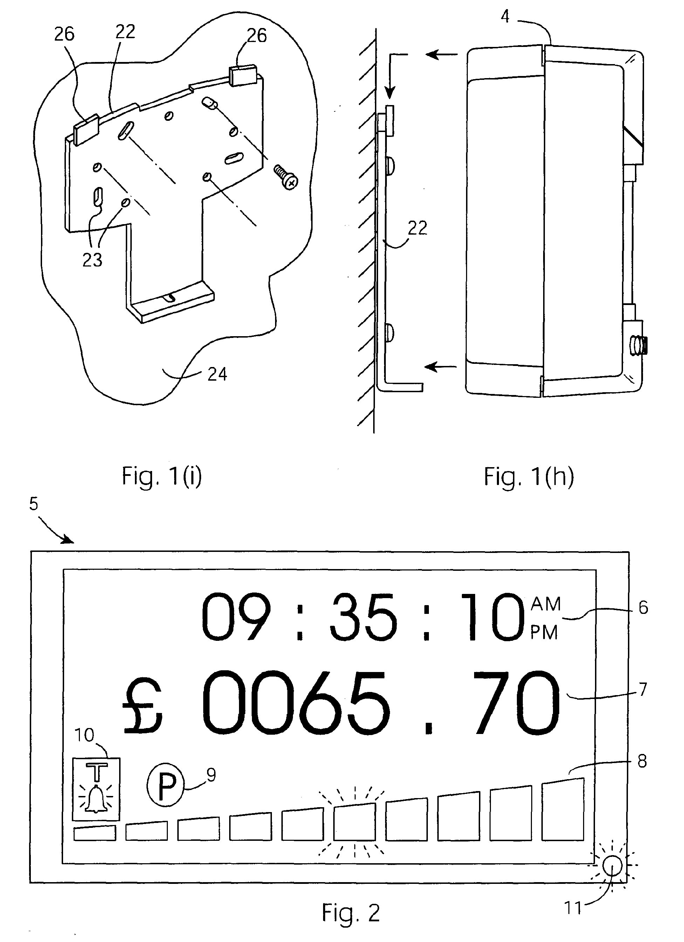

The unit 2 comprises a housing 4 and a display 5 which provides electricity flow information in an manner which is very clear and easy to read. As shown most clearly in Fig. 2, the display 5 comprises upper and lower alphanumeric sequences 6 and 7, a display ramp 8, a program mode indicator 9, and a tamper alarm indicator 10. The unit 2 also includes a red LED 11 mounted beside the display 5. The Led 11 is a high intensity broad angle LED, visible from a wide area.

The system 1 is installed by a user simply inserting the plug 16 into a conventional socket, and clipping the current transformer 3 in place around the relevant cable. Of course, the system 1 may alternatively be hard-wired into a distribution board if desired.

The system 1 monitors both current flow and voltage level in a circuit in a non-intrusive manner. These signals are processed by both flow interface and user interface circuits within the unit 2. A microprocessor within the user interface circuit is programmable to provide cost or usage information according to parameters inputted by the user. These values may be accumulated cost and consumption values between a reset period and the current time or they may be historical accumulated costs for previous periods. There is complete flexibility in use of the display sequences 6 and 7 by appropriate programming of the microprocessor. In another example, one display sequence may be used for displaying the consumption of night-rate electricity and the other for day-rate electricity.

An important aspect of the system 1 is that in addition to providing accumulated cost and/or usage data 7, it also provides a dynamic real time visual indication of current consumption. This is by way of the ramp 8 which has ten segments increasing in height in a ramp configuration. One of these segments is illuminated at any one point in time to indicate the level of the current consumption at that point in time. Another very important aspect is use of the flashing LED 11. This LED flashes at a rate which is proportional to the current consumption. This is very important. For example, if one is leaving a house the flashing LED 11 provides an immediate clearly-visible indication of the level of electricity consumption. This may, for example, indicate that an appliance has been inadvertently left switched on. This is very important for safety, as it may indicate, for example, that a heater or other potentially dangerous appliance has been inadvertently left switched on.

The indicator 9 indicates that the unit 2 is in program mode and the indicator 10 is a tamper indicator. Tamper detection is described in more detail below.

Thus, the unit 2 provides important accumulated data which is up to date in real time, and also provides data indicating the instantaneous consumption. This effectively provides a dual function for the system, and the latter function is extremely important for day-to-day use.

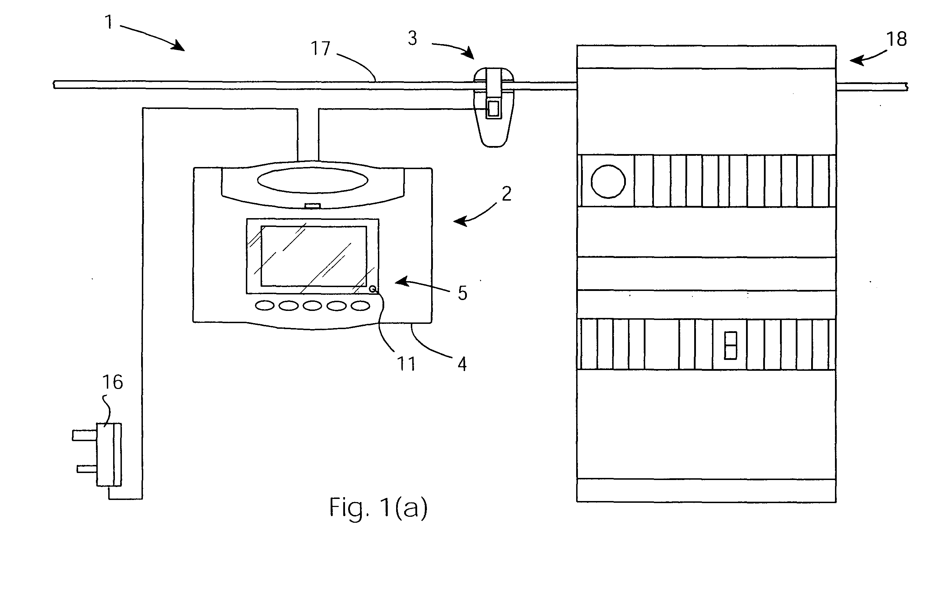

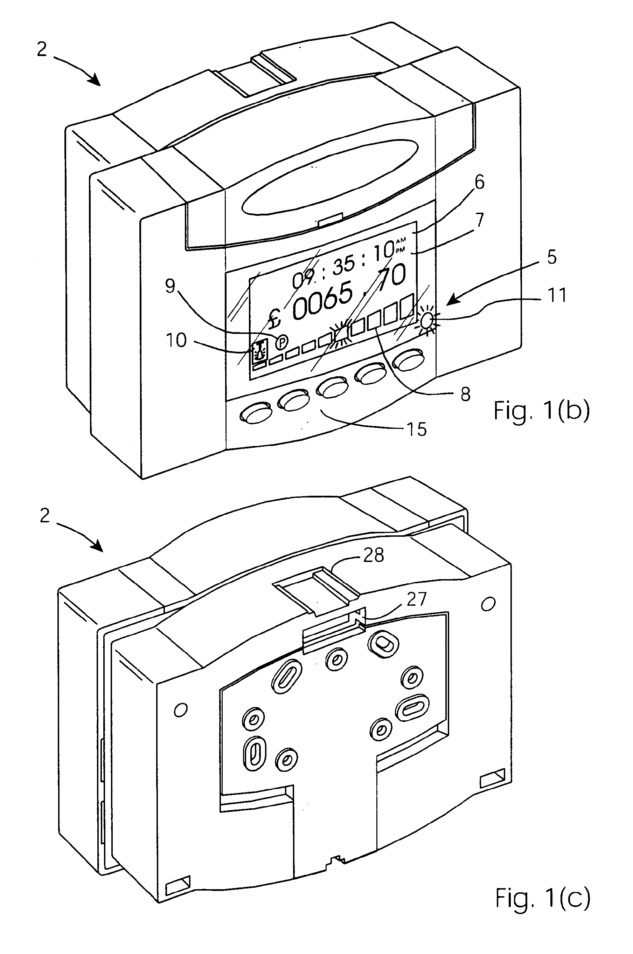

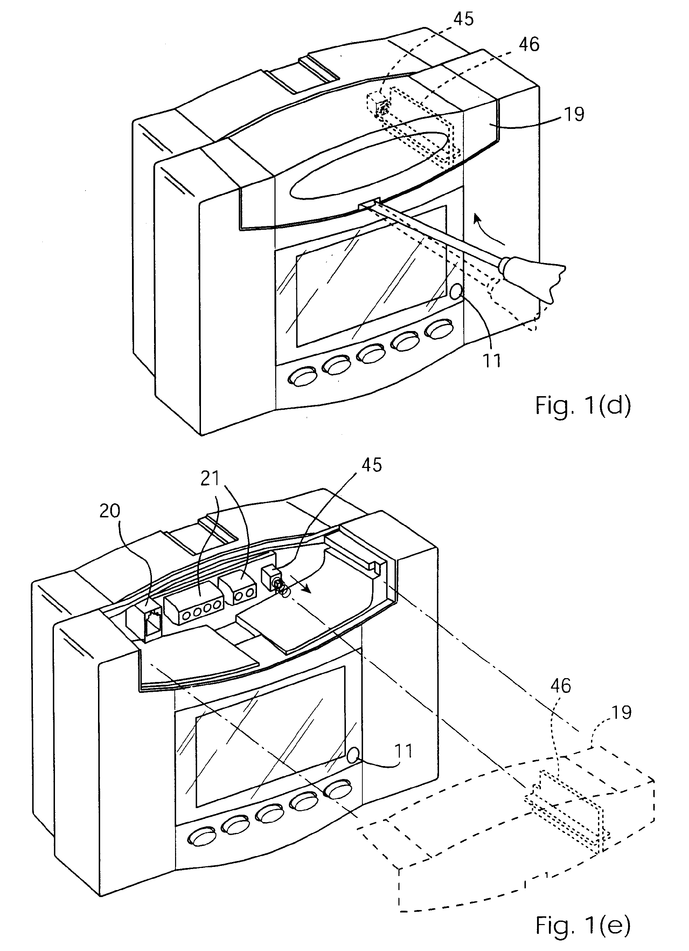

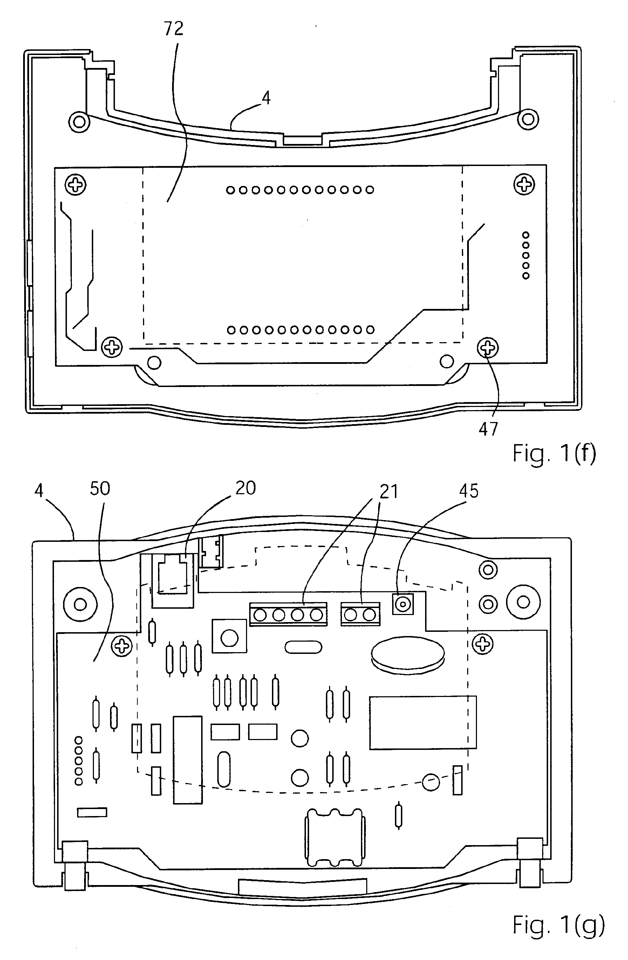

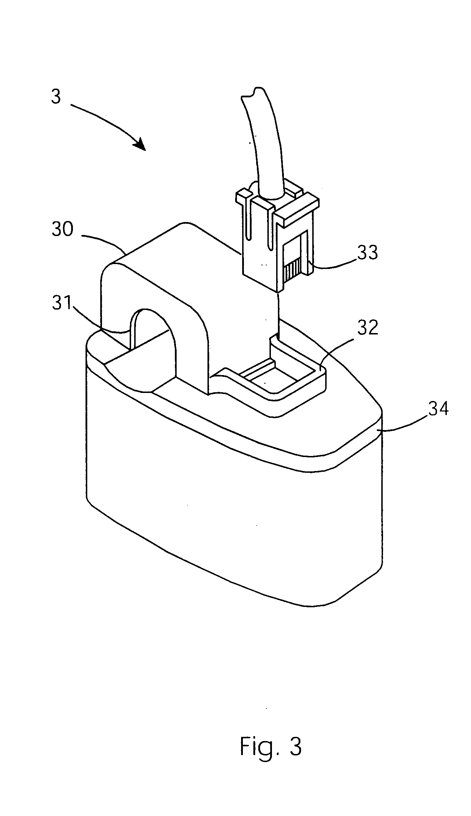

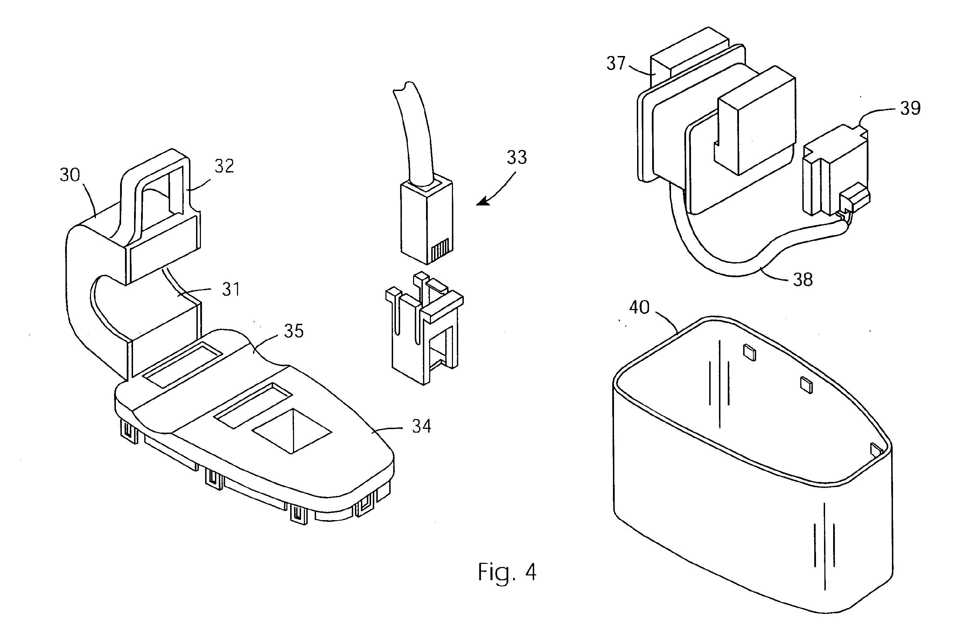

Referring again to Figs. 1(a) to 1(i), the unit 2 comprises a set of buttons 15 which allow a user to perform functions such as setting time, resetting the cost calculation, and setting peak and off-peak hours on a 24-hour clock basis. A conventional 3-pin plug 16 provides mains power to the unit and is used by it to determine the voltage level in the electricity supply being monitored. The current transformer 3 (described in more detail below with reference to Figs. 3 and 4) is clipped in place around a power supply cable 17 carrying the supply being monitored. This provides a current level measurement to the unit 2. In the illustration of Fig. 1, the unit 2 is shown mounted close to a conventional circuit breaker and distribution panel 18.

As shown particularly in Figs. 1(d) and 1(e), the casing 4 includes a cover 19 which is normally used for installation. It requires use of a tool for removal, and this reveals a socket 20 for connection to the current transformer 3 and mains terminals 21. A microswitch and plunger/spring assembly 45 which is normally in contact with a protruding part 46 of the cover 19 detects opening of the cover 19 after installation and this is recorded as an alarm.

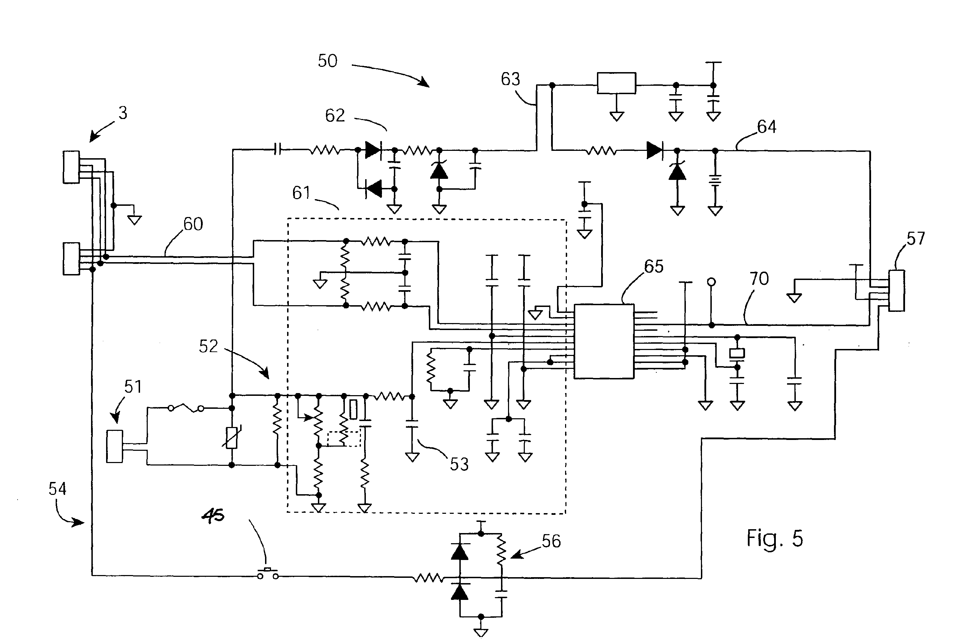

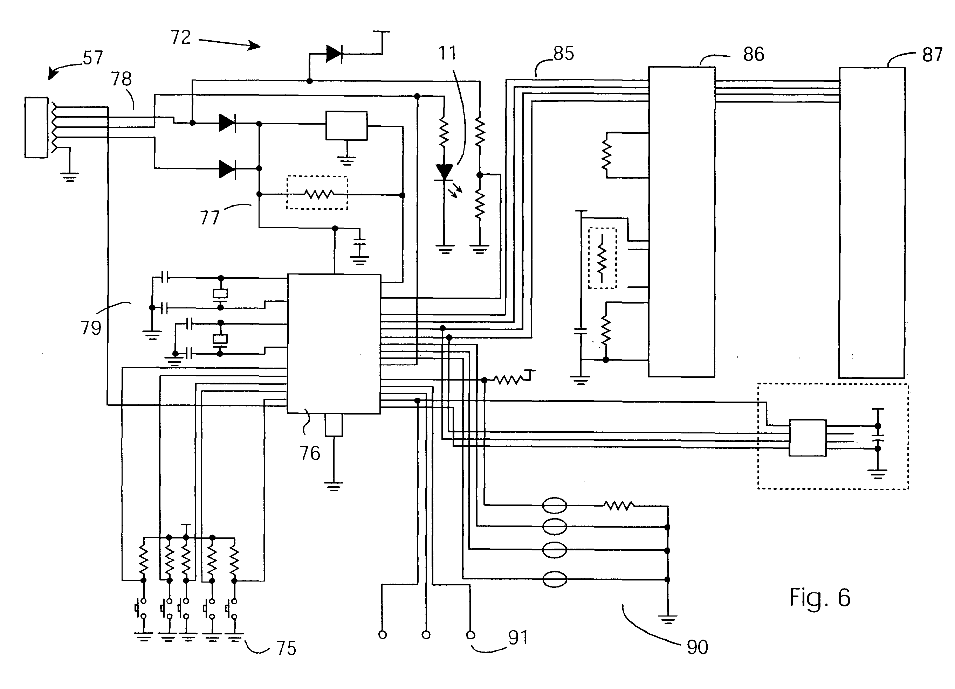

The housing 4 houses a front, user interface circuit 72 and a rear, flow interface circuit 50. Both of these circuits are described in more detail below with reference to Figs. 5 and 6. The circuits 50 and 72 are interconnected by a ribbon cable. A potentiometer for calibration is mounted on the user interface circuit 72 in a location where it may be accessed by simply removing the cover 19. The user interface circuit 72 PCB is fixed in position on pillars 47 which are part of the moulding of the front part of the housing 4. This avoids the need for PCB stand-offs between boards and gives excellent alignment with keypad contacts. The keypad fits directly onto the user interface circuit 72 by engagement of plugs on the keypad with apertures in the PCB. This also provides excellent keypad alignment. The LCD display area is configured to allow light from above to enter at an angle of 45°. This improves clarity of the LCD display because it allows ceiling lights to provide effective illumination. The LCD lens is held in place in a cambered display area of the front of the housing 4 by plastics walls which are part of the front of the cover. The rear housing part incorporates strain-relief formations for both a mains cable and for a signal cable from the current transformer 3.

Referring particularly to Fig. 1(g), the unit 2 comprises a mounting plate 22 having several screw holes to provide excellent versatility for mounting onto a wall 24 or conduit box or panel. The housing 4 rests on a lower ledge 25 of the mounting plate 22 and engages upstanding tabs 26. It will be apparent for Fig. 1(c) that the mounting plate 22 allows cables to be trained through a small opening 27 for rear cable entry, or alternatively a blank 28 may be knocked out for entry via minitrunking.

Referring to Figs. 3 and 4, the current transformer 3 is illustrated. The current transformer 3 comprises a hinged part 30 which has an elongate recess 31 and a socket 32 for receiving a plug 33 of a signal cable connected to the unit 2. The hinged part 30 is hinged to a base 34 having an elongate recess 35 co-operating with the recess 31. The base 34 is mounted over a transformer 37 which is connected by a signal cable 38 to a connector 30 which connects with the plug 33 to provide a current signal. These latter components are mounted within a casing 40.

The current transformer 3 may be very easily connected to monitor current flow in a cable by simply closing the hinged part 30 over the cable so that it runs through the recesses 31 and 35. The level of current flow is picked up by the transformer 37. which supplies a signal proportional to the current flow.

Tampering is detected because it is not possible to disconnect the transformer without first disconnecting the plug 33, thus providing a tamper indication.

Referring now to Fig. 5, the unit houses a flow interface circuit 50. The circuit 50 comprises mains terminals 51 for receiving a mains supply, in this embodiment 230V. This is passed through a potential divider 52 and a filter 53. This provides a sense input to a voltage-to-frequency converter 65 such as that marketed by Analog Devices under the code name AN-7750™ . The terminals 51 are also connected to an anti-tamper circuit 54 which comprises a detector in the unit 2 to detect opening of the housing. The detector comprises the microswitch and plunger assembly 45. When the cover is closing the plunger pushes against the spring, which in turn activates the microswitch. This circuit passes through a transient filter 56 and terminates in a connector 57.

The current transformer 3 provides a signal on a signal line 60. This is converted to a voltage signal by a current-to-voltage converter 61.

Thus, the voltage-to-frequency converter 65 receives two voltage sense inputs, one from the potential divider 52 and the filter 53 indicating the mains voltage level, and one from the current-to-voltage converter 61 indicating the mains current level. The converter 65 provides an output signal on a line 70 connected to the connector 57. The output signal is in the form of pulses, the frequency of which is proportional to the power consumption.

The connector 57 is connected to a user interface circuit 72 which processes the pulse signal on the line 70 in order to generate user information. Keypad circuitry 75 is connected to the keypads on the unit 2 and this allows user programming of a microprocessor 76 to set various configurations of output data using the real time and dynamic power consumption inputs. The user interface circuit 72 also comprises a battery protection circuit 77 for the microprocessor 76. Signal lines from the connector 57 are indicated by the numeral 78 and the pulse signal is also directed to the LED 11 as illustrated in Fig. 6. Thus, without a need for any processing to take place, the LED 11 provides a dynamic real time and very clear visual indication of current consumption. Oscillators 79 provide clock signals for the microprocessor 76.

The microprocessor 76 processes the various inputs in order to generate the information which is displayed on the display unit 5. This is by way of output LCD conductors 85 connected to a LCD driver 86, in turn connected to an LCD 87 which provides the alphanumeric sequences 6 and 7 and the ramp 8.

Both of the circuits 50 and 72 include a large number of test pads for effective automatic in-circuit testing.

The microprocessor 76 is also connected to an I²C bus 90 and to various links 91 which allow settings to be hard-wired. One such setting is domestic or commercial selection. In the domestic selection there may be no provision for a landlord PIN or anti-tamper function. This allows very simple product configuration.

In operation, the current transformer 3 is connected at the appropriate electrical cable to sense the current flow in the cable. This may be the primary mains cable into a building, a cable of a subcircuit, or indeed a cable to a particular appliance or group of appliances. Voltage is very conveniently measured by simply tapping off the voltage supply to the unit itself. This is typically quite stable at 230V AC. Thus, the system 1 may be used in a non-intrusive manner to monitor power consumption for one or a variety of different circuits within a building.

As described above, there is a very comprehensive display of information and options may be easily set by cutting links 91 and/or by programming via the keypad 12. In the example illustrated, the cost may be displayed in French Francs. Deutschmarks, Dollars, Euros, or Pounds. Also, as described above, the cost may be for a period between the last reset and the present time, or for a previous period, or for an on-going set of periods such as night rate or day-rate metering including accumulated night costs and accumulated day costs separately. Also, the interface circuit retains the last bill totals so that the user can very easily check the accumulated totals for the last billing period. In addition, the user is provided with a very clear and visible indication of the present rate of consumption. This acts, in effect, as a high-consumption alarm so that the system has a dual purpose of both providing cost information and also an alarm for consumption the present time.

The microprocessor is also programmed to recognise a special key sequence inputted by a user if the PIN is forgotten/lost. This allows a new PIN to be set without recourse to the manufacturer. However, following this procedure the tamper indicator 10 flashes for twenty-one days afterwards. This provides a warning to the user if a non-authorised user attempted the procedure. This activation of the tamper indicator 10 can not be stopped before expiry of the twenty-one day period.

Versatility achieved by programming the microprocessor 76 is very useful. For example, electricity utilities provide numerous tariff structures which are available to consumers. It is important for the consumer to choose the most appropriate structure and this can be greatly facilitated by use of the system 1 over a period of time to indicate the level of consumption for different time periods. This can be very important for minimising the power costs of an organisation. Also, the microprocessor is programmed to calculate and display cost on the basis of different unit costs for usage bands as set up in tarriff structures.

The basic architecture of the system 1 lends itself to excellent versatility whereby it may be used in a range of different applications. Its architecture comprises a sensor which in one embodiment is a current transformer; a flow interface, which in this embodiment is the flow interface circuit 50; and a user interface which in this embodiment is the interface circuit 72 and the associated display 5 and the keypad 12. Thus, the sensor may be a different type of sensor such as a fluid flow sensor which generates a voltage signal proportional to the flow rate of a medium such as gas or water. The flow interface circuit processes such a signal in a manner equivalent to that for electricity and generates a pulse signal which is proportional to the flow rate. This signal is available for use by one or a number of different user interfaces and the connection may be wired or wireless. For example, a flow interface and associated sensor may be mounted in a transformer or meter room of a large factory, however, the user interface may be mounted in an office some distance away whereby a person with responsibility for cost control can conveniently monitor electricity cost.

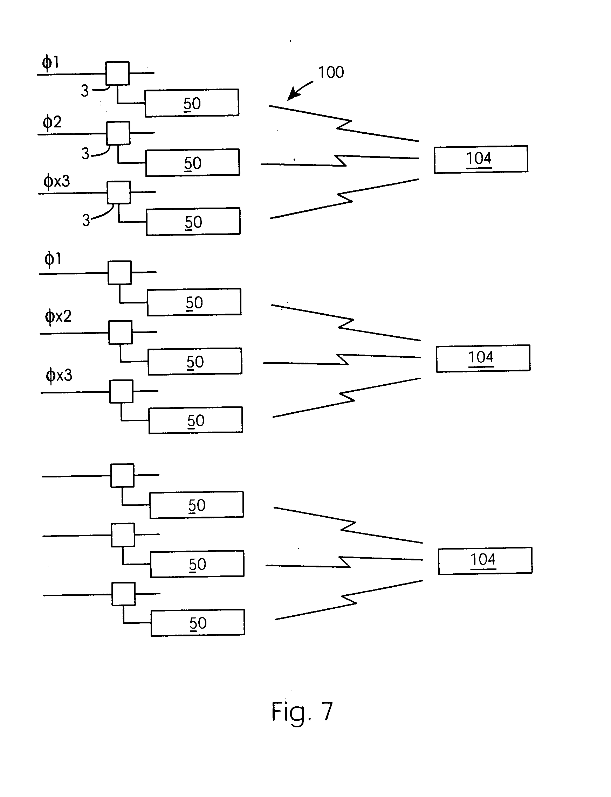

There may be a number of user interfaces at different locations, all connected to the same flow interface. On the other hand, there may be a number of different flow interfaces, each associated with an associated power phase in an industrial environment. Each phase is monitored in an equivalent manner and may be processed by a user interface to provide cost information as required. In one example, a central PC may receive flow data from a flow interface in every apartment in an apartment block. The user interface on a central monitoring station may be remote for large-scale centralised monitoring. The tamper circuits 54 of the flow interfaces may be linked to form a complete circuit for all phases. Such an arrangement is illustrated diagrammatically in Fig. 7, in which there are three supplies 100, 101, and 102 in a large industrial plant. Each supply comprises three phases and there is a current transformer 3 and a flow interface circuit 50 associated with each phase. There is only one user interface 104 per supply, however, there may be multiple user interfaces with wired or wireless connections to the associated flow interface circuits 50.

Thus, the basic architecture of the system 1 provides excellent versatility both in the nature of the medium being monitored, and also in the nature of the user interaction which is required. The system may also take the form of a small, portable, weatherproof unit which may be mounted on a temporary power supply, for example in a building site. This provides a cost indication for power consumption on a temporary basis. Thus, the system would be very useful for builders or trades people. The system may alternatively be mounted in a machine to provide a power consumption cost for a pre-set time period, or on a job-by-job basis. For example, moulding machines consume large quantities of power and this application would be extremely useful and would allow an operator to invoice the actual cost of electricity for a particular job.

The invention is not limited to the embodiments described, but may be varied in construction and detail. For example, the interface may be connected to an input device whereby it resets when the input device is activated by a person reading the meter. This allows the system to synchronise with billing periods. Also, the flow interface may sense flow according to a meter such as an electricity utility meter. In this embodiment, power may be sensed using the shunt resistor technique wired directly to the supply. Another embodiment of the invention may involve monitoring wattless power/power factor, particularly in industrial environments. It is also envisaged that the system may comprise a printer or a printer driver for printing of data. Tampering may be detected by mechanical tamper-evident arrangements on the housing such as tamper-evident seals.

## Claims

1. A real time flow monitoring system comprising:-
a flow interface comprising means for generating a flow signal representing flow of a medium being monitored; and
a user interface comprising means for processing the flow signal and for generating a user output of data such as cost in real time.

2. A real time flow monitoring system as claimed in claim 1, wherein the flow signal is frequency-modulated.

3. A real time flow monitoring system as claimed in claim 2, wherein the flow signal represents a flow unit as a pulse, whereby pulse frequency represents flow.

4. A real time flow monitoring system as claimed in claims 2 or 3, wherein the user interface comprises means for activating a light emitter to flash at a frequency related to flow to provide a strong visual indication.

5. A real time flow monitoring system as claimed in any preceding claim. wherein the user interface comprises means for storing accumulated flow values between a reset time and the present time.

6. A real time flow monitoring system as claimed in claim 5, wherein the user interface comprises means for storing historical accumulated values for pre-set time periods.

7. A real time flow monitoring system as claimed in claim 6, wherein the user interface comprises means for adding accumulated values for time periods which are repeated such as time 00.00 to 08.00 every day.

8. A real time flow monitoring system as claimed in any preceding claim, wherein the user interface comprises a display comprising a ramp in which flowrate is represented as a position on the ramp.

9. A real time flow monitoring system as claimed in any preceding claim, wherein the user interface comprises means for displaying both cost and flow data.

10. A real time flow monitoring system as claimed in any preceding claim. wherein the user interface is connected in a tamper-detection circuit comprising means for detecting opening of a housing for the system.

11. A real time flow monitoring system as claimed in claim 10, wherein the user interface comprises means for generating an alarm output indicating a tampering occurrence, and said alarm output preferably comprises a dedicated light emitter.

12. A real time flow monitoring system as claimed in ary preceding claim, wherein the flow interface comprises means for sensing electricity consumption, and the flow interface comprises a current transformer connected to a current voltage converter.

13. A real time flow monitoring system as claimed in claim 12, wherein the flow interface comprises a voltage divider connected to a power cable for the system.

14. A real time flow monitoring system as claimed in claims 12 to 13, wherein the current transformer comprises a base and a hinged part which co-operate to surround a cable and support a magnetic transformer in proximity to the cable.

15. A real time flow monitoring system as claimed in claim 14, wherein the current transformer comprises a socket for a signal connector, and the socket is in the hinged part.

16. A real time flow monitoring system as claimed in ary preceding claim, wherein the user interface is located remotely from the flow interface.

17. A real time flow monitoring system as claimed in claim 16, wherein the flow interface and the user interface comprise means for wireless communication.

18. A real time flow monitoring system as claimed in any preceding claim. wherein the user interface comprises means for communication with a plurality of flow interfaces.

19. A real time flow monitoring system as claimed in claim 18, wherein the user interface comprises means for processing electricity consumption flow signals from each of multiple phases.

20. A real time flow monitoring system as claimed in any of claims 12 to 19 wherein the flow interface comprises means for determining electrical consumption from an electricity meter.

21. A real time flow monitoring system as claimed in claim 20, wherein the flow interface comprises a sensor operable according to the shunt resistor power detection technique.

22. A real time flow monitoring system as claimed in any preceding claim, wherein the system comprises a housing for the user interface, the housing comprising a removable mounting plate for mounting on a wall.

23. A real time flow monitoring system as claimed in claim 22, wherein the housing and the mounting plate comprises a plurality of apertures and at least one blank piece to allow a plurality of paths for training signal and power cables into the circuits.

24. A real time flow monitoring system as claimed in any preceding claim, wherein a housing for the user interface comprises a cambered transparent section behind which a display is mounted.

25. A real time flow monitoring system as claimed in claim 24, wherein the display comprises means for allowing entry of light from above at an angle of up to 45°.

26. A current sensor comprising a body having means for non-intrusively surrounding an electrical cable to retain a current transformer in proximity to the cable, and an output port for delivery of a current sense signal to a monitoring device.
